# EUROPÄISCHE PATENTSCHRIFT

(11) **EP 1 408 548 B1**
(45) Veröffentlichungstag und Bekanntmachung des Hinweises auf die Patenterteilung: **05.01.2011**
(21) Anmeldenummer: 03022722.7
(22) Anmeldetag: 09.10.2003
(51) Int. Cl.: H01L 23/495, H01L 21/56

(54) **Verfahren zur Herstellung eines elektronischen Bauelements mit einem Systemträger**
Method of manufacturing an electronic component with a lead frame
Procédé pour la fabrication d'un composant électronique avec grille de connexion

(30) Priorität: 11.10.2002 DE 10247610
(43) Veröffentlichungstag der Anmeldung: 14.04.2004
(73) Patentinhaber: Micronas GmbH, 79108 Freiburg i. Br. (DE)
(72) Erfinder: Hauser, Wolfgang, 79346 Endingen (DE); Joos, Christian, 79238 Ehrenkirchen (DE); Heitzler, Viktor, 79224 Umkrich (DE)
(74) Vertreter: Koch, Bertram

(56) Entgegenhaltungen:
- US-A- 4 451 973
- US-A- 5 427 938
- US-B1- 6 255 722
- PATENT ABSTRACTS OF JAPAN Bd. 013, Nr. 429 (E-823), 25. September 1989 (1989-09-25) -& JP 01 158756 A (SANKEN ELECTRIC CO LTD), 21. Juni 1989 (1989-06-21)
- PATENT ABSTRACTS OF JAPAN Bd. 010, Nr. 337 (E-454), 14. November 1986 (1986-11-14) -& JP 61 140157 A (NEC CORP), 27. Juni 1986 (1986-06-27)
- PATENT ABSTRACTS OF JAPAN Bd. 007, Nr. 272 (E-214), 3. Dezember 1983 (1983-12-03) -& JP 58 154252 A (HITACHI SEISAKUSHO KK), 13. September 1983 (1983-09-13)
- PATENT ABSTRACTS OF JAPAN Bd. 2002, Nr. 06, 4. Juni 2002 (2002-06-04) -& JP 2002 040058 A (SANKEN ELECTRIC CO LTD), 6. Februar 2002 (2002-02-06)

## Beschreibung

Die vorliegende Erfindung betrifft ein Verfahren zur Herstellung eines elektronischen Bauelement gemäß dem Patentanspruch 1.

Ein solches Bauteil ist z. B. aus US 6,255,722 B1 bekannt.

Ein Verfahren zur Herstellung eines elektronischen Bauteils durch ein Umpressverfahren ist aus JP-A-01158756 bekannt.

Ein elektronisches Bauelement weist in der Regel einen Systemträger, bestehend aus zumindest einer Plattform und gegebenenfalls zumindest einem elektrischen Anschlussstück, zumindest ein elektronisches Bauteil sowie ein Gehäuse auf. Hierbei ist das zumindest eine elektronische Bauteil auf der Plattform angeordnet. Des weiteren sind das elektronische Bauteil und die Plattform in der Regel vollständig von dem Gehäuse umgeben.

Das Gehäuse des elektronischen Bauelements wird in der Regel durch ein Umpressverfahren, den sogenannten Moldvorgang, hergestellt. Beim Moldvorgang ragt der zu umpressende Teil des Systemträgers, nämlich zumindest die Plattform, mit dem auf ihm angeordneten elektronischen Bauteil ungeschützt in die Kavität der Gussform, dem sogenannten Moldwerkzeug. Beim Umpressen wird die Umpressmasse mit hohen Einspritzdrücken in die Kavität des Moldwerkzeugs eingebracht. Des weiteren herrscht während des Umpressvorgangs in der Kavität eine ungleichmäßige Druckverteilung durch die Umpressmasse. Daraus folgend, kann beim Umpressen der in die Kavität ragende Abschnitt des Systemträgers verbogen werden. Dies kann zur Folge haben, dass sich die elektrischen und magnetischen Eigenschaften des elektronischen Bauteils in unerwünschter Weise verändern. So wird beispielsweise bei einem Hallsensor durch Verkippen der Plattform, auf der das Sensorelement angeordnet ist, die Empfindlichkeit verschlechtert.

Der zu umpressende Teil des Systemträgers ist in der Regel ein Abschnitt eines endlosen Metallbandes, eines sogenannten Leadframes. Bekannt ist es, an den Leadframes Stützelemente vorzusehen, die im Anschluss an den Moldvorgang noch aus dem Gehäuse herausragen und entlang der Außenfläche des Gehäuses abgeachnitten werden.

Nachteilig dabei ist, dass die Stützelemente meist auch nach dem Abtrennen geringfügig aus dem Gehäuse ragen und keinen ebenen Abschluss mit der Gehäusewand bilden.

Ein solches Hinausragen der Abstützelemente aus dem Cehäuse zeigt auch die eingangs erwähnte US 6,235,722, weil dort die beiden Abstützelemente an den oberen, freien Kanten des Systemträger gebildet sind.

Des weiteren wird der Systemträger beim Abtrennen der Stützelemente mechanisch beansprucht, was zu Beschädigungen an der Plattform und Verschiebungen des elektronischen Bandelements innerhalb des Gehäuses einerseits und aufgrund der Bewegungen zu ungenügend dichten Übergangsbereichen zwischen der Plattform und den Stützelementen andererseits führen kann.

Der vorliegenden Erfindung liegt daher die Aufgabe zugrunde, ein elektronisches Bauelement vorzuschlagen, bei welchem die Gefahr einer Beschädigung des elektronischen Bauelements vermindert ist.

Die Aufgabe wird erfindungsgemäß durch ein ein Verfahren mit den Merkmalen des Patentanspruchs 1 gelöst.

Das elektronische Bauelement gemäß der Gattung weist einen Systemträger auf, bestehend aus einer Plattform und gegebenenfalls zumindest einem elektrischen Anschlussstück. Des weiteren ist beim gattungsgemäßen elektronischen Bauelement zumindest ein elektronisches Bauteil vorgesehen, welches auf der Plattform angeordnet ist. Darüber hinaus weist das gattungsgemäße elektronische Bauelement ein Gehäuse auf, welches das e-elektronische Bauteil und die Plattform umgibt. Beim erfindungsgemäß herzustellenden elektronischen Bauelement ist darüber hinaus an der Plattform zumindest ein Anlagebereich zum Abstützen der Plattform während des Herstellungsprozesses des Gehäuses vorgesehen, wobei dieser zumindest eine Anlagebereich zumindest abschnittweise aus dem Gehäuse des elektronischen Bauelements ragt.

Vorzugsweise ragt der zumindest eine Anlagebereich in eine Aussparung des Gehäuses, wobei er die Aussparung nur teilweise überdeckt. Damit steht der Anlagebereich nach dem Moldvorgang nicht über die Außenmaße des Gehäuses hinaus.

Durch die Erfindung wird erreicht, dass während des Moldvorgangs der frei in die Kavität des Moldwerkzeugs ragende Bereich des Systemträgers, nämlich die Plattform, durch das Moldwerkzeug abgestützt wird. Daraus folgend, wird in dem Abschnitt des Anlagebereichs der durch das Moldwerkzeug abgestützt wird, beim Umpressvorgang keine Umpressmasse angelagert, wodurch der Anlagebereich zumindest abschnittweise aus dem Gehäuse ragt. Dabei liegt dieser Abschnitt vorteilhafterweise in einer Aussparung des Gehäuses, so dass der Anlagenbereich nicht über die Außenmaße des Gehäuses hinausragt.

Weiterhin wird durch die Erfindung erreicht, dass jede Plattform separat fixiert und umspritzt wird. Die Plattformen sind dabei nicht mehr Teil eines Leadframes, so dass kein Abtrennen der Plattform aus dem Leadframe nötig ist, wodurch ein Verbiegen der Plattform durch mechanische Belastungen vermieden wird. Zusätzlich wird durch die Einbettung der Anlagebereiche in Aussparungen des Gehäuses vermieden, dass die Anlagebereiche über die Außenmaße des Gehäuses hinaus stehen.

Das zumindest eine Nasenelement ist einstückig an die Plattform angeformt, so dass die Plattform und das Nasenelement kostengünstig als Stanzteil gefertigt werden können.

Da das Nasenelement bzw. der Anlagebereich zumindest abschnittweise aus dem Gehäuse ragt, ist das Nasenelement bzw. der Anlagebereich zumindest abschnittweise der Umgebungsfeuchtigkeit direkt ausgesetzt. Um ein Eindringen der Umgebungsfeuchtigkeit in das Gehäuse im Übergangsbereich zwischen der Plattform und dem Nasenelement bzw. Anlagebereich und damit in das Gehäuse zu unterbinden, ist entlang des Übergangsbereichs eine kerbenartige Vertiefung vorgesehen.

Das zumindest eine Anschlussstück ist einstückig an die Plattform angeformt, so dass das Anschlussstück und die Plattform eine integrale Einheit bilden. Hierbei verläuft das Anschlussstück zumindest abschnittweise außerhalb des Gehäuses. Daraus folgend, kann der Systemträger beim Moldvorgang zusätzlich durch das Anschlussstück abgestützt werden.

Gemäß einem besonders bevorzugten Ausführungsbeispiel weist das elektronische Bauelement drei oder mehr Anschlussstücke auf, welche parallel verlaufen und auf einer Seite des Gehäuses aus diesem geführt werden. Als konkrete Ausführungsform dieser Ausgestaltung ist beispielsweise ein Hallsensor zu nennen.

Nach einer weiteren bevorzugten Ausführungsform erstreckt sich auf dem Nasenelement zumindest abschnittweise ein dünner Korrosionsschutzfilm. Ein mögliches Beispiel besteht darin, dass der Anlagebereich mit einem dünnen Film des Gehäusekunststoffs überzogen ist. Der dünne Film kann beispielsweise bei der Herstellung des Gehäuses geschaffen werden, indem zwischen Anlagebereich und Gussform ein kleiner Hohlraum besteht, der durch den Kunststoff beim Einspritzen des Kunststoffs ausgefüllt wird.

Nach einem weiteren bevorzugten Ausführungsbeispiel ist der Systemträger aus einem Metall oder aus einer Metalllegierung gefertigt.

Des weiteren sieht eine bevorzugte Ausführungsform vor, dass die Oberfläche des Systemträgers zumindest abschnittweise beschichtet und insbesondere mit einer Legierung, die Zinn- oder Zinn-Blei enthält, beschichtet ist.

Gemäß dem Verfahren zur Herstellung des elektronischen Bauelements ist vorgesehen, dass beim Umpressen der in die Kavität der Gussform ragende Anlagebereich des Systemträgers, nämlich die Plattform in zumindest einem Bereich durch die Gussform abgestützt wird. Wie die Abstützung im Detail erfolgt ist für das Prinzip der Erfindung nicht ausschlaggebend. So ist beispielsweise denkbar, in der oberen und unteren Schale der Gussform jeweils zumindest ein stiftartiges Element vorzusehen, so dass der Anlagebereich während des Umpressvorgangs zwischen den Stiftelementen der oberen und unteren Schale der Gussform eingeklemmt wird. Vorzugsweise ist die Gussform so ausgebildet, dass die Anlagebereiche in Aussparungen des Gehäuses zu liegen kommen. Des weiteren ist es möglich, die Stiftelemente als integralen Bestandteil der Seitenwandung der Moldschalen des Moldwerkzeugs bzw. der Gussform auszubilden.

Nachfolgend wird die Erfindung anhand von schematischen Zeichnungen auf der Grundlage eines bespielhaft bevorzugten Ausführungsbeispiels weiter veranschaulicht. Es zeigen:
- Figur 1: ein erfindungsgemäß herzustellendes elektronisches Bauelement in schematischer Darstellung in Draufsicht,
- Figur 2: das erfindungsgemäß herzustellendes elektronische Bauelement in Seitenansicht,
- Figur 3: das erfindungsgemäß herzustellendes elektronische Bauelement in perspektivischer Darstellung,
- Figur 4: das erfindungsgemäß herzustellende elektronische Bauelement wäh- rend der Herstellung des Gehäuses in Schnittrichtung A-A der Figur 1.

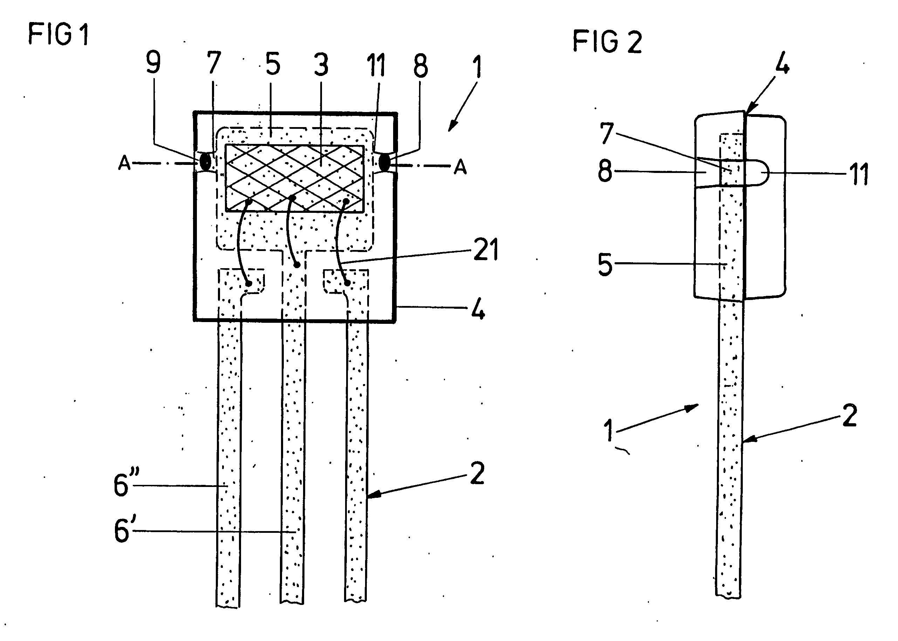

Die Figur 1 zeigt ein erfindungsgemäß herzustellendes elektronisches Bauelement 1 mit einem Systemträger 2 einem elektronischen Bauteil 3 sowie einem Gehäuse 4 in Draufsicht.

Im vorliegenden Ausführungsbeispiel weist das elektronische Bauelement 1 einen Systemträger aus einer Metalllegierung auf. Darüber hinaus ist das Gehäuse 4 aus einem Kunststoff, wie beispielsweise Epoxydharz, gefertigt. Das elektronische Bauteil 3 des elektronischen Bauelements 1 ist im vorliegenden Ausführungsbeispiel ein Hall-Sensorelement.

Der Systemträger 2 weist eine Plattform 5 sowie drei zueinander parallel verlaufende Anschlussstücke 6', 6" auf. Das Anschlussstück 6' ist im vorliegenden Ausführungsbeispiel einstückig an die Plattform 5 angeformt. Die Anschlussstücke 6" ragen in das Gehäuse 4 des elektronischen Bauelements 1, ohne direkten Kontakt zur Plattform 5, hinein. Das elektronische Bauteil 3 ist auf der Plattform 5 angeordnet. Die elektrische Kontaktierung des elektronischen Bauteils 3 mit den Anschlussstücken 6'und 6" ist durch Bondverbindungen 21 innerhalb des Gehäuses 4 realisiert. Über die Anschlussstücke 6', 6" wird die elektrische Verbindung des elektronischen Bauteils 3 in den Bereich außerhalb des Gehäuses 4 vermittelt. An der Plattform 5 sind des weiteren zwei gegenüberliegend angeordnete Nasenelemente 7 einstückig angeformt. Wie in der Figur 1 zu erkennen ist, weist das Gehäuse 4 im Bereich jedes Nasenelements 7 Aussparungen 8 auf, die als Supportholes bezeichnet werden. Der in der Figur 1 dunkel gezeichnete Abschnitt 9 stellt den Überlappungsbereich zwischen jeweils einem Nasenelement 7 und einem Supporthole 8 dar, d. h. dass jedes Nasenelement 7 im Überlappungsbereich 9 über das Gehäuse 4 hinausragt. Dabei überdeckt das Nasenelement 7 das Supporthole 8 jedoch nur teilweise, so dass es nicht über die Außenmaße des Gehäuses 4 hinausragt. Des weiteren ist im Übergang zwischen Plattform 5 und Nasenelement 7 jeweils eine kerbenförmige Vertiefung 10 vorgesehen, durch welche verhindert wird, dass Umgebungsfeuchte im Bereich der Suppcrtholes 8 in das Gehäuse 4 eindringen kann.

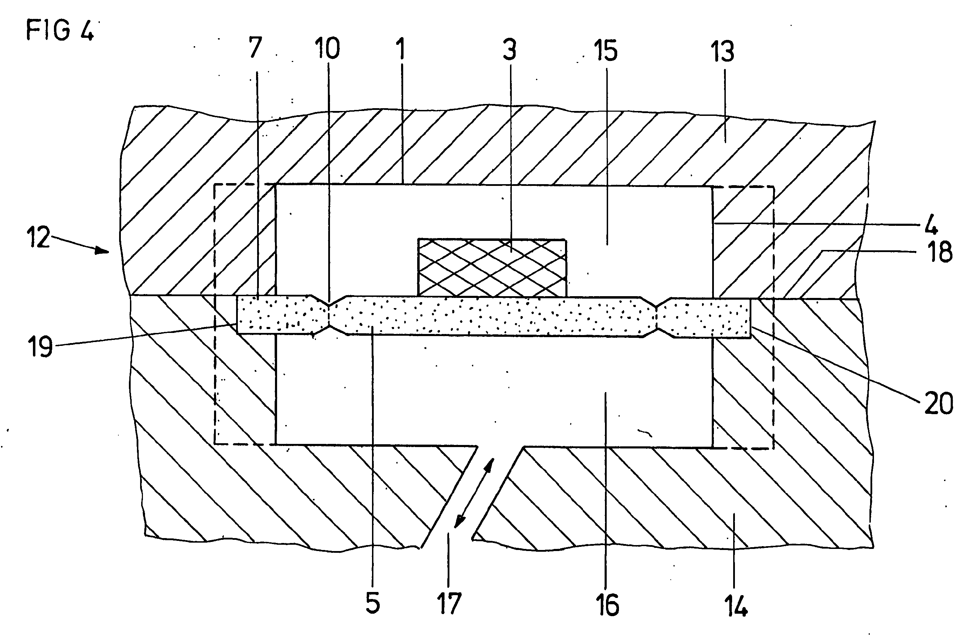

In Figur 2 ist das in Figur 1 beschriebene elektronische Bauelement 1 in Seitenansicht dargestellt, wobei innerhalb des Gehäuses 4 nur die Plattform 5 sowie ein Nasenelement 7 dargestellt sind. Als neuer Aspekt gegenüber der Figur 1 ist das auf der Unterseite des Gehäuses 4 befindliche Supporthole 11 zu nennen. Das Supporthole 11 ist dem Supporthole 8 gegenüberliegend angeordnet. Durch das Supporthole 11 wird bewirkt, dass die Unterseite des Nasenelements 7 abschnittsweise aus dem Gehäuse 4 ragt. Durch das Supporthole 8 wird bewirkt, wie bereits in Figur 1 beschrieben, dass die Oberseite des Nasenelements 7 aus dem Gehäuse 4 ragt. Im Bereich der Supporthole 8 und 11 wird die Plattform 5 mittels der Nasenelemente 7 beidseitig gegenüber der Gussform 12 (in Figur 4 dargestellt) beim Umpressvorgang abgestützt, wodurch ein Kippen der Plattform 5 beim Umpressvorgang verhindert wird.

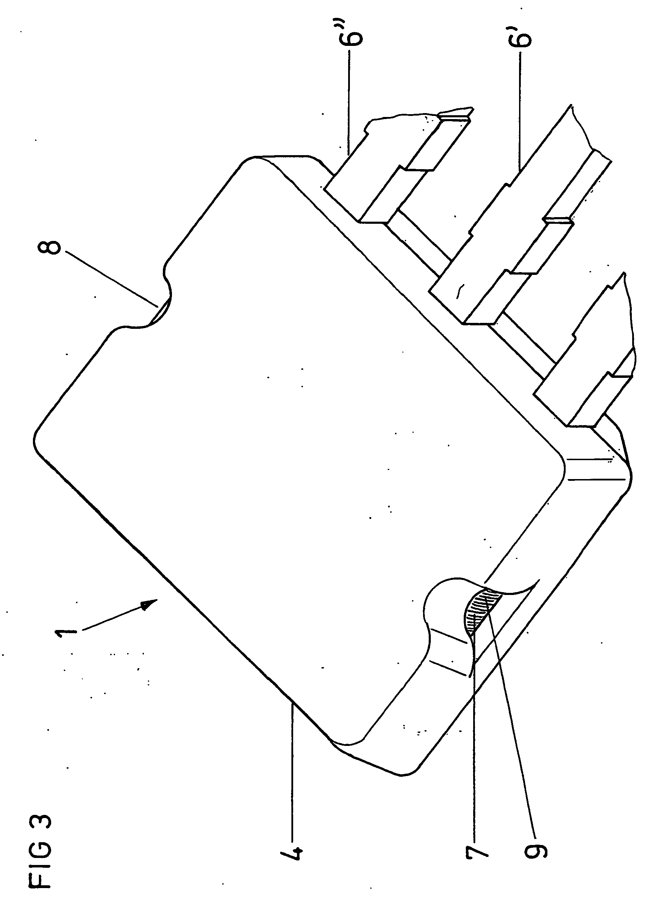

Die Figur 3 zeigt das elektronische Bauelement 1 zur besseren Verständlichkeit in perspektivischer Darstellung. Deutlich sichtbar ist der Überlappungsbereich 9, in welchem das Nasenelement 7 in das Supporthole 8 hineinragt. Dabei wird jedoch nur eine Bereich des Supportholes 8 überdeckt, so dass das Nasenelement 7 nicht über die Außenmaße des Gehäuses 4 hinausragt. Beim Moldvorgang sind die Supportholen 8 von der Gussform ausgefüllt, wodurch die Plattform 5 über die Nasenelemente 7 in der Gussform stabilisiert wird.

Die Figur 4 zeigt das elektronische Bauteil 1 bei der Herstellung des Gehäuses 4 in Schnittrichtung A-A der Figur 1. Man erkennt das Moldwerkzeug 12, welches aus einer oberen Moldschale 13 und einer unteren Moldschale 14 besteht. Während des Umpressvorgangs sind die Umpressschalen 13 und 14 entlang einer Trennebene 18 zur Anlage gebracht, so dass durch das Moldwerkzeug 12 eine geschlossene Kavität, bestehend aus den Kavitätenhälften 15 und 16 gebildet wird. In der unteren Moldschale 14 ist exemplarisch ein Kanal 17 zum Befüllen der Kavitätenhälften 15 und 16 mit Umpressmasse dargestellt. Weiter erkennt man, dass die gegenüberlisgerd angeordneten und an die Plattform 5 einstückig angeformten Nasenelemente 7 im Bereich der Trennebene 18 durch die obere Moldschale 13 und die untere Moldschale 14 abgestützt werden. Zur Aufnahme jedes Nasenelements 7 sind dazu in der oberen Moldschale 13 Aussparungen 19 sowie in der unteren Moldschale 14 Aussparungen 20 vorgesehen, wobei im zusammengepresstem Zustand der Moldschalen 13 und 14 die Aussparungen 19 und 20 einen formkomplementären Raum zum jeweils aufgenommenen Nasenelement 7 ausbilden.

### Bezugszeichenliste

- 1: elektronisches Bauelement
- 2: Systemträger
- 3: Elektronisches Bauteil
- 4: Gehäuse
- 5: Plattform
- 6': Anschlussstück
- 6": Anschlussstück
- 7: Nasenelement
- 8: Supporthole Gehäuse)
- 9: (Oberseite Überlappungsbereich
- 10: Kerbenförmige Vertiefung
- 11: Supporthole (Unterseite Gehäuse)
- 12: Gussform / Moldwerkzeug
- 13: Obere Moldschale
- 14: Untere Moldschale
- 15: Obere Kavitätenhälfte
- 16: Untere Kavitätenhälfte
- 17: Befüll- bzw. Entlüftungskanal
- 18: Trennebene
- 19: Aussparung (obere Moldschale)
- 20: Aussparung (untere Moldschale)
- 21: Bondverbindung

## Patentansprüche

1. Verfahren zur Herstellung eines elektronischen Bauelements (1) mit einem Systemträger (2), mit einer Plattform (5) auf der ein elektronisches Bauteil (3) angeordnet ist und mit einem durch eine Umpressverfahren mittels einer Gussform (12) hergestellten Gehäuse (4), welches das elektronische Bauteil (3) und die Plattform (5) umgibt, sowie mit einer Abstützvorrichtung zum Abstützen der Plattform (5) während des Herstellungsprozesses des Gehäuses, wobei als Abstützeinrichtung an der Plattform (5) zwei gegenüberliegend angeordnete Nasenelemente (7) einstückig angeformt sind,
wobei bei dem Verfahren die Plattform (5) mittels der Nasenelemente (7) beim Umpressvorgang beidseitig gegenüber der Gussform abgestützt wird, so dass in dem Abschnitt der Nasenelemente (7), der abgestützt wird, beim Umpressvorgang keine Umpressmasse abgelagert wird, wodurch die Nasenelemente (7) zumindest abschnittweise aus dem Gehäuse (4) ragen, und das Gehäuse (4) im Bereich jedes der Nasenelemente (7) zwei sich gegenüberliegende Supportholes (8,11) aufweist, wobei die Nasenelemente (7) die Supportholes (8,11) nur teilweise überdecken, so dass die Nasenelemente (7) nicht über die Außemaße des Gehäuses (4) hinausragen,
wobei
die Plattform (5) separat fixiert und umspritzt wird, wobei die Plattform (5) nicht Teil eines Leadframes ist.

## Claims

1. Method for producing an electronic component (1) with a system support (2), a platform (5) on which an electronic component (3) is arranged, and a housing (4), which is produced by an encapsulating moulding method by means of a mould (12) and which surrounds the electronic component (3) and the platform (5), as well as a support device for supporting the platform (5) during the process of production of the housing, wherein as support device two oppositely arranged lug elements (7) are integrally formed at the platform (5), wherein in the method the platform (5) is supported by means of the lug elements (7) at both sides relative to the casting mould during the encapsulating moulding process so that no encapsulating moulding material is deposited in the section of the lug elements (7), which is supported, during the encapsulating moulding process, whereby the lug elements (7) protrude at least in sections out of the housing (4) and the housing (4) has in the region of each of the lug elements (7) two mutually opposite support holes (8, 11), wherein the lug elements (7) only partly cover the support holes (8, 11) so that the lug elements (7) do not protrude beyond the external dimensions of the housing (4), wherein the platform (5) is separately fixed and injection-moulded around and wherein the platform (5) is not part of a lead frame.

## Revendications

1. Procédé de fabrication d'un composant électronique (1) comportant un système porteur (2) et une plateforme (5) sur laquelle est monté un composant électronique (3) et un boîtier (4) fabriqué par un procédé d'enrobage au moyen d'un moule de fonderie (12) qui entoure le composant électronique (3) et la plateforme (5), comportant aussi un dispositif d'appui pour soutenir la plateforme (5) pendant le procédé de fabrication du boîtier, procédé selon lequel on forme d'une seule pièce deux éléments saillants (7) disposés de façon opposée et selon lequel la plateforme (5) est appuyée sur les éléments saillants (7) bilatéralement de part et d'autre du moule de fonderie de façon que l'appui se faisant dans la partie des éléments saillants, ne détache aucune masse d'enrobage au cours de l'étape d'enrobage, procédé selon lequel les éléments (7) font saillie du boîtier (4) au moins localement et le boîtier (4) dans la région de chaque élément saillant (7) présente deux ouvertures de support (8, 11), les éléments saillants (7) ne couvrant que partiellement les ouvertures de support (8, 11) de façon que les éléments saillants (7) ne sortent pas à l'extérieur du boîtier, et selon lequel la plateforme (5) est fixée et enrobée séparément et dans lequel la plateforme (5) ne fait pas partie d'une grille de connexion.
